# EUROPEAN PATENT APPLICATION

(11) **EP 3 929 988 A1**
(43) Date of publication of application: **29.12.2021**
(21) Application number: 19915767.8
(22) Date of filing: 03.09.2019
(51) Int. Cl.: H01L 27/15, H01L 33/00, H01L 21/768

(54) **DISPLAY PANEL AND MANUFACTURING METHOD THEREFOR**

(30) Priority: 18.02.2019 KR 20190018739
(71) Applicant: ELK Corporation, Daejeon 34013 (KR); Shin, Dong Hyuk, Yuseong-gu Daejeon 34033 (KR)
(72) Inventor: SHIN, Dong Hyuk, Daejeon 34033 (KR)
(74) Representative: Spengler, Robert
(86) International application number: PCT/KR2019/011287
(87) International publication number: WO 2020/171325

(57) **Abstract**

A manufacturing method of a display panel for a micro LED display includes providing a substrate, a plurality of micro LEDs formed on the substrate, a switching circuit formed on an upper surface of the substrate to control the micro LEDs, a plurality of upper electrodes formed on one side of the upper surface of the substrate to correspond to an end of the switching circuit, a driving circuit unit formed on a lower surface of the substrate, and a plurality of lower electrodes formed on one side of the lower surface of the substrate to correspond to the driving circuit unit, forming a first mask formed with a connecting slit connecting the upper electrodes and the lower electrodes via an upper surface, a side surface, and a lower surface of the substrate, forming a first mask formed with a connecting slit connecting the upper electrodes and the lower electrodes via an upper surface, a side surface, and a lower surface of the substrate, and forming a metal connection pattern connecting the upper electrodes and the lower electrodes on the substrate by removing the first mask.

## Description

### [Technical Field]

The present invention relates to a display, and more particularly, to a display panel and a method for manufacturing the display panel capable of mounting a micro LED as a unit substrate to be assembled for a display.

### [Background Art]

A display using a micro LED refers to a display in which a micro LED having a size of 100 µm or less as 1/10 of an existing LED is mounted on a substrate. For reference, if the existing LDE is implemented by using a white LED as a white light source and pixels are implemented by using a control of an LCD liquid crystal and a color filter, the micro LED display may self-emit light by independently driving the micro LED as red (R), green (G), and blue (B) pixels directly.

In terms of "self-emission", since the micro LED display may be similar to an OLED display, but may use an LED chip itself as a pixel, the micro LED display may be suitable for implementing a flexible or rollable display and has advantages in color reproduction, power consumption, and response speed.

The LED is typically fabricated on a sapphire substrate and also fabricated even on a silicon substrate, and in order to manufacture a large LED display such as a TV or an electronic board, generally, display panels or display modules on which a plurality of micro LEDs are mounted are manufactured and then these display panels are assembled to implement a large display.

Korean Patent Publication No. 10-2018-0053864 relates to a micro LED display pixel assembly and a manufacturing method thereof and discloses a micro LED display operating on a generate substrate without a TFT back plane.

### [Disclosure]

### [Technical Problem]

The present invention is to solve the problems of the technique of mounting the micro LED and provides a display panel and a manufacturing method thereof for electrically connecting a micro LED mounted on an upper surface of a substrate and a driving circuit disposed on a lower surface thereof.

### [Technical Solution]

According to an embodiment of the present invention, a manufacturing method of a display panel for a micro LED display includes providing a substrate, a plurality of micro LEDs mounted on the substrate, a switching circuit formed on an upper surface of the substrate to control the micro LEDs, a plurality of upper electrodes formed on one side of the upper surface of the substrate to correspond to an end of the switching circuit, a driving circuit unit formed on a lower surface of the substrate, and a plurality of lower electrodes formed on one side of the lower surface of the substrate to correspond to the driving circuit unit, forming a first mask formed with a connecting slit connecting the upper electrodes and the lower electrodes via an upper surface, a side surface, and a lower surface of the substrate, forming a first mask formed with a connecting slit connecting the upper electrodes and the lower electrodes via an upper surface, a side surface, and a lower surface of the substrate, and forming a metal connection pattern connecting the upper electrodes and the lower electrodes on the substrate by removing the first mask.

The metal thin film may be formed by a method such as sputtering, chemical vapor deposition, pulsed laser deposition (PLD), E-beam evaporation, thermal evaporation, and metal-organic molecular beam epitaxy (MOMBE). Since an adhesive layer does not remain on the substrate in the connection slit, the metal connection pattern may be clearly formed.

The manufacturing method may further include forming a second mask to cover a region other than a region corresponding to the first mask of the substrate before the metal thin film is formed. In a method such as sputtering among the methods of forming the metal thin film above, since the metal thin film may be entirely formed on the surface at low pressure, the second mask may be further formed to protect the plurality of micro LEDs, the switching circuit, the driver circuit unit, etc.

However, in the case of using a method capable of selectively forming the metal thin film instead of sputtering, for example, when the metal connection pattern is formed between the connection slits using inkjet printing or stamping, the second mask needs not be formed.

However, when the second mask is formed, the second mask may be formed before, at the same time of, or after forming the first mask.

The first mask may be formed by using a photosensitive film such as a dry film photoresist (DFR) film. In the case of using the photosensitive film, the forming of the first mask may be classified as follows in the order of patterning and attaching of the film.

As an example, in the forming of the first mask, the photosensitive film may be first exposed positively or negatively to correspond to the connection slit, the connection slit may be formed by removing a portion corresponding to the connection slit from the photosensitive film, and the photosensitive film formed with the connection slit may be attached via the upper surface, the side surface, and the lower surface of the substrate.

As another example, in the forming of the first mask, the photosensitive film may be attached via the upper surface, the side surface, and the lower surface of the substrate, the photosensitive film may be exposed positively or negatively to correspond to the connection slit, and the connection slit may be formed by removing a portion corresponding to the connection slit from the photosensitive film.

The photosensitive film may be formed with a thickness of about 5 µm to 100 µm, and a protective film may be further attached to cover the upper surface, the side surface, and the lower surface of the substrate simultaneously, after forming the metal connection pattern by removing the photosensitive film.

According to another embodiment of the present invention, a display panel using a micro LED includes a substrate, a plurality of micro LEDs mounted on the substrate, a switching circuit formed on an upper surface of the substrate to control the micro LEDs, a plurality of upper electrodes formed on one side of the upper surface of the substrate to correspond to an end of the switching circuit, a driving circuit unit formed on a lower surface of the substrate, and a plurality of lower electrodes formed on one side of the lower surface of the substrate to correspond to the driving circuit unit, and further includes a plurality of metal connection patterns connecting the upper electrodes and the lower electrodes via a side surface of the substrate, wherein each metal connection pattern includes first ends corresponding to the upper electrodes and second ends corresponding to the lower electrodes, respectively, wherein the first end covers an upper surface of the upper electrode and the second end covers a lower surface of the lower electrode.

Here, since the metal connection pattern is formed by a process of forming a metal thin film by deposition and the like, adhesive layers may not be present between the first end of the metal connection pattern and the upper electrode and between the second end and the lower electrode, which may be electrically in direct contact with each other.

As described above, the metal thin film may be formed by sputtering, chemical vapor deposition, pulsed laser deposition (PLD), E-beam evaporation, thermal evaporation, or metal-organic molecular beam epitaxy (MOMBE), and the substrate is a TFT glass substrate and via holes are not directly formed on the substrate, but may be formed via the upper surface, the side surface, and the lower surface of the substrate.

### [Advantageous Effects]

According to the present invention, the micro LED display panel may solve the problems of the technique of mounting thousands of micro LEDs, and the micro LEDs mounted on the upper surface of the substrate and the driving circuit unit disposed on the lower surface are connected with the metal connection pattern formed by the deposition process to bypass, but are formed on the substrate closely with a fine thickness to improve the accuracy of the work, and a sheet resistance is relatively very low to form a stable electrical connection.

In the display panel, the upper electrodes and the lower electrodes are electrically connected to each other through the metal connection patterns, and the metal connection patterns do not almost protrude from the outer surface of the substrate, but may be in close contact with each other via the upper surface, the side surface, and the lower surface of the substrate. Therefore, there is no need to form via holes to electrically connect the upper and lower portions of the panel, and the plurality of metal connection patterns may be formed directly on the substrate to be in close contact with each other with a minimum thickness, thereby removing a gap lifted even if the display panels are in close contact with each other.

### [Description of Drawings]

FIG. 1 is a view for describing a micro LED display and a display panel used for an assembly thereof according to an embodiment of the present invention.
FIG. 2 is a view for describing a cross section of the micro LED display panel of FIG. 1.
FIG. 3 is a view for describing a first mask used for manufacturing a micro LED display panel according to an embodiment of the present invention.
FIG. 4 is a view for describing a process of forming the first mask of FIG. 3.
FIG. 5 is a view for describing a process of manufacturing a micro LED display panel according to an embodiment of the present invention using the first mask of FIG. 3.

### [Modes of the Invention]

Hereinafter, exemplary embodiments of the present invention will be described in detail with reference to the accompanying drawings, but the present invention is not limited or restricted to the exemplary embodiments. For reference, in the description, like reference numerals substantially refer to like elements, which may be described by citing contents disclosed in other drawings under such a rule and contents determined to be apparent to those skilled in the art or repeated may be omitted.

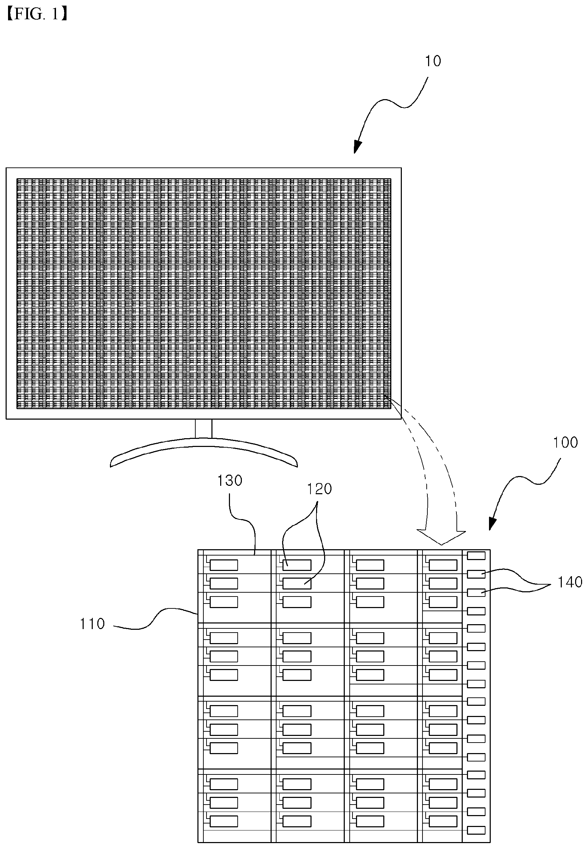

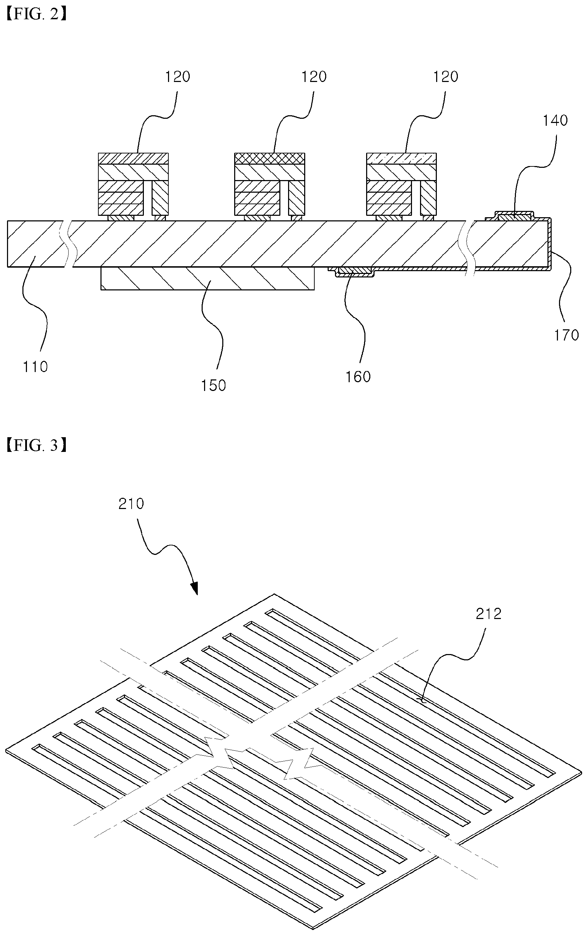

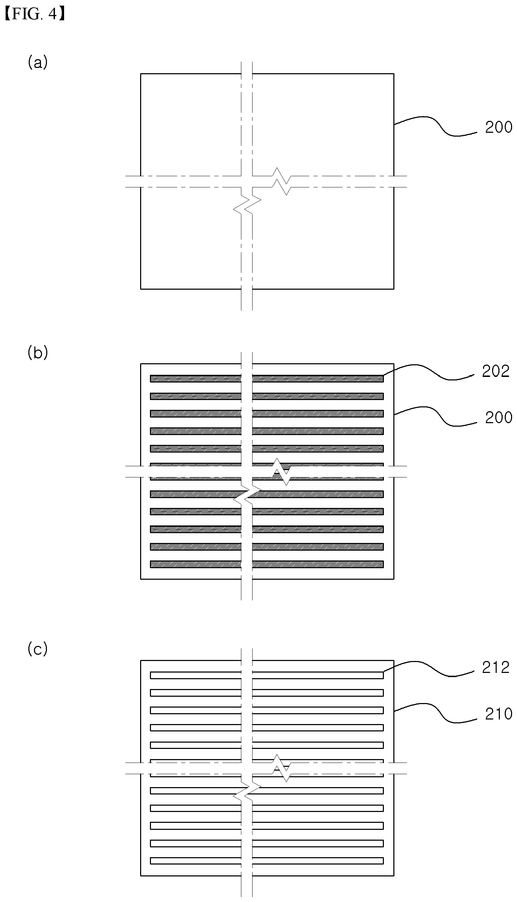

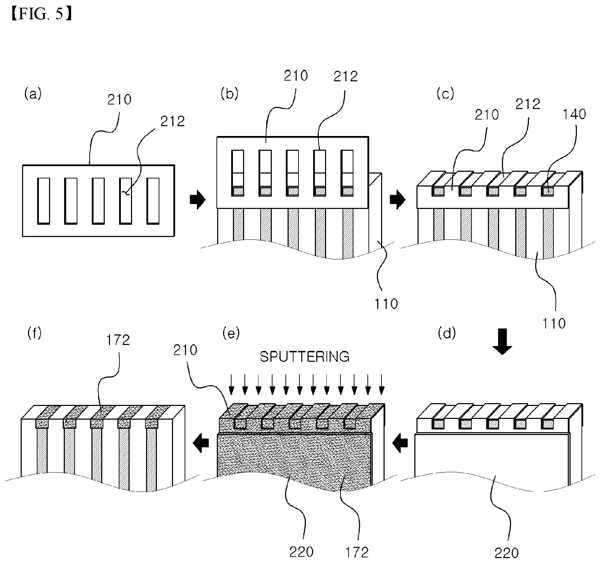

FIG. 1 is a view for describing a micro LED display and a display panel used for an assembly thereof according to an embodiment of the present invention, FIG. 2 is a view for describing a cross section of the micro LED display panel of FIG. 1, FIG. 3 is a view for describing a first mask used for manufacturing a micro LED display panel according to an embodiment of the present invention, FIG. 4 is a view for describing a process of forming the first mask of FIG. 3, and FIG. 5 is a view for describing a process of manufacturing a micro LED display panel according to an embodiment of the present invention using the first mask of FIG. 3.

Referring to FIGS. 1 to 5, a display panel 100 according to an embodiment of the present invention may be applied to a micro LED display 10. In general, a UHD or 4K-level display may be mounted with about 24 million of LEDs. However, it may be unreasonable that 24 million of LEDs are mounted on one surface, and a method of dividing these LEDs into modules with display panels and assembling the display panels 100 one by one to fabricate one display may be used.

As an example, when a 100-inch UHD display is fabricated, about 260 display panels of 10cm ^{∗} 10cm mounted with LEDs may be used and assembled. Further, about 93,000 micro LEDs need to be mounted on each display panel 100.

Referring to FIG. 2, the display panel 100 for the micro LED display 10 may include a substrate 110, a plurality of micro LEDs 120 mounted or formed on the substrate 110, a switching circuit 130 formed on an upper surface of the substrate 110 to control the micro LEDs 120, a plurality of upper electrodes 140 formed on one side of the upper surface of the substrate 110 to correspond to an end of the switching circuit 130, a driving circuit unit 150 formed on a lower surface of the substrate 110, a plurality of lower electrodes 160 formed on one side of the lower surface of the substrate 110 to correspond to the driving circuit unit 150, and a metal connection pattern 170 closely adhered to one side of the substrate 110 to electrically connect the upper electrodes 140 and the lower electrodes 160.

The substrate 110 may be formed with the switching circuit 130 formed with a TFT as a glass substrate, and a circuit may be formed on the substrate 110 using amorphous silicon, polysilicon, IGZO, etc. The micro LEDs 120 may be electrically mounted on the switching circuit 130 by a process such as soldering, etc.

Further, the upper electrodes 140 and the lower electrodes 160 formed on the substrate 110 may be formed using silver paste, molybdenum disulfide (MoS₂), metal meshes or silver nanowires, and may be formed even using a material of oxide-metal-oxide (OMO).

The driving circuit unit 150 may be provided to the lower surface of the substrate 110. The driving circuit unit 150 is to control the micro LEDs 120 mounted on the panel and may receive an image signal from a central processor of the micro LED display to transmit the image signal to the micro LEDs 120 mounted on the corresponding display panel 100.

In the display panel 100, the upper electrodes 140 and the lower electrodes 160 are electrically connected to each other one-to-one by the metal connection pattern 170, and the metal connection pattern 170 is formed directly on an outer surface of the substrate 110 via the upper surface, the side surface, and the lower surface from one side of the substrate 110 to maintain a close contact with a very small thickness. Accordingly, there is no need to form via holes to electrically connect the upper and lower portions of the panel, and the metal connection pattern 170 is formed directly on the substrate 110 to be most closely adhered to the substrate 110, thereby removing or minimizing a gap lifted even if the display panels 100 are in close contact with each other.

Further, since the metal connection pattern 170 is directly formed by a method such as deposition and sputtering as described below, an adhesive layer is not present between the electrode and the connection pattern and there is no concern that the electrical connection is unstable due to sheet resistance by the adhesive layer.

In addition, the metal connection pattern 170 includes first ends 172 corresponding to the upper electrodes 140 and second ends 174 corresponding to the lower electrodes 160, respectively, and the metal connection pattern 170 may be formed directly on the substrate 110 by a first mask 210 for forming the ends.

Referring to FIGS. 3 and 4, the first mask 210 for forming the metal connection pattern 170 on the substrate 110 may include a connection slit 212 corresponding to the metal connection pattern 170.

The first mask 210 may be formed by using a photosensitive film 200 such as a dry film photoresist (DFR) film. The photosensitive film may be selectively formed with a pattern corresponding to the connection slit by exposure, and the first mask 210 may be formed by selectively removing the pattern corresponding to the connecting slit using an exposed portion and a non-exposed portion.

The first mask 210 may be formed with a length corresponding to one side of the substrate 110 and may include a connection slit 212 finely designed to connect the upper electrodes 140 and the lower electrodes 160 one-to-one. In the embodiment, the connection slit 212 may be formed in advance before the first mask 210 is adhered to the substrate 110, but after the photosensitive film is first adhered to the substrate, a portion corresponding to the connection slit may be removed through an exposure process.

Referring to FIG 4, first, the photosensitive film 200 is provided (a). As the photosensitive film 200, a DFR film may be used and a film having a thickness of about 5 µm to 100 µm may be used. Next, the photosensitive film 200 is exposed positively or negatively to correspond to the connection slit (b), and the connection slit 212 is formed by removing a portion corresponding to the connection slit 212 from the photosensitive film 200 to form a film corresponding to the first mask 210.

Referring to FIG. 5, the first mask 212 formed with the connection slit 212 is provided (a), and the first mask 210 is attached via the upper surface, the side surface, and the lower surface of the substrate 110 (b). At this time, alignment may be performed so that the connection slit 212 corresponds to the upper electrodes 140 and the lower electrodes 160, and the upper electrodes 140, the lower electrodes 160, and a part of the substrate 110 connecting the electrodes may be exposed by the first mask 210.

The first mask 210 may be maintained to be attached in an approximately C shape to one side of the substrate 110 (c), and to this end, a conventional or alternative technique for film lamination may be used.

In addition, a remaining part which is not masked by the first mask 210 may be masked by a second mask 220. The second mask 220 is to protect the plurality of micro LEDs 120, the switching circuit 130, the driving circuit unit 150, etc. and may be formed by entirely laminating the film or coating the entire surface with masking ink.

While the first mask 210 and the second mask 220 are formed, the substrate 110 may be subjected to a process such as sputtering in deposition equipment. As a result, a metal thin film 172 may be formed on the outer surface of the substrate 110 (e).

While the metal thin film is formed, the first mask 210 and the second mask 220 may be removed or peeled using chemicals such as acetone (f). After the first mask 210 and the second mask 220 are removed, a part of the metal thin film remains on the substrate 110 to form the metal connection pattern 170, and the metal connection pattern 170 may function as a good wire pattern which electrically connects the upper electrodes 140 and the lower electrodes 160.

According to the embodiment, in the process of forming the metal connection pattern 170, since an adhesive layer does not remain between the electrodes and the metal connection pattern 170, low resistance may be maintained and clean and rigid electric connection may be formed.

In the embodiment, the metal thin film may be formed by a method such as sputtering, chemical vapor deposition, pulsed laser deposition (PLD), E-beam evaporation, thermal evaporation, and metal-organic molecular beam epitaxy (MOMBE).

Although not illustrated, after the metal connection pattern 170 is formed, a protective film is additionally attached to protect the metal connection pattern 170. The protective film may be formed using an elastic material such as polyurethane by various methods such as laminating and coating. The protective film may prevent bubbles from being generated between the film and the substrate by elasticity and prevent the metal connection pattern 170 from be damaged or disconnected by external impact.

As described above, the present invention has been described with reference to the preferred embodiments. However, it will be appreciated by those skilled in the art that various modifications and changes of the present invention can be made without departing from the spirit and the scope of the present invention which are defined in the appended claims and their equivalents.

## Claims

1. A manufacturing method of a display panel for a micro LED display, comprising:
providing a substrate, a plurality of micro LEDs mounted on the substrate, a switching circuit formed on an upper surface of the substrate to control the micro LEDs, a plurality of upper electrodes formed on one side of the upper surface of the substrate to correspond to an end of the switching circuit, a driving circuit unit formed on a lower surface of the substrate, and a plurality of lower electrodes formed on one side of the lower surface of the substrate to correspond to the driving circuit unit,
forming a first mask formed with a connecting slit connecting the upper electrodes and the lower electrodes via an upper surface, a side surface, and a lower surface of the substrate;
forming a metal thin film on an outer surface of the substrate formed with the first mask; and
forming a metal connection pattern connecting the upper electrodes and the lower electrodes on the substrate by removing the first mask.

2. The manufacturing method of a display panel of claim 1, further comprising:
forming a second mask to cover a region other than a region corresponding to the first mask of the substrate before the metal thin film is formed.

3. The manufacturing method of a display panel of claim 2, wherein the second mask is formed before, at the same time of, or after forming the first mask.

4. The manufacturing method of a display panel of claim 1, wherein the first mask is formed using a photosensitive film.

5. The manufacturing method of a display panel of claim 4, wherein the photosensitive film is a dry film photoresist (DFR) film.

6. The manufacturing method of a display panel of claim 4, wherein in the forming of the first mask, the photosensitive film is exposed positively or negatively to correspond to the connection slit, the connection slit is formed by removing a portion corresponding to the connection slit from the photosensitive film, and the photosensitive film formed with the connection slit is attached via the upper surface, the side surface, and the lower surface of the substrate.

7. The manufacturing method of a display panel of claim 4, wherein in the forming of the first mask, the photosensitive film is attached via the upper surface, the side surface, and the lower surface of the substrate, the photosensitive film is exposed positively or negatively to correspond to the connection slit, and the connection slit is formed by removing a portion corresponding to the connection slit from the photosensitive film.

8. The manufacturing method of a display panel of claim 4, wherein the photosensitive film is formed with a thickness of 5 µm to 100 µm.

9. The manufacturing method of a display panel of claim 1, wherein the metal thin film is formed by sputtering, chemical vapor deposition, pulsed laser deposition (PLD), E-beam evaporation, thermal evaporation, or metal-organic molecular beam epitaxy (MOMBE).

10. The manufacturing method of a display panel of claim 1, further comprising:
attaching a protective film to cover simultaneously the upper surface, the side surface, and the lower surface of the substrate to correspond to the metal connection pattern.

11. The manufacturing method of a display panel of claim 1, wherein at least one of the upper electrodes or the lower electrodes is formed using silver paste, molybdenum disulfide (MoS₂), metal meshes or silver nanowires.

12. A display panel including a substrate, a plurality of micro LEDs mounted on the substrate, a switching circuit formed on an upper surface of the substrate to control the micro LEDs, a plurality of upper electrodes formed on one side of the upper surface of the substrate to correspond to an end of the switching circuit, a driving circuit unit formed on a lower surface of the substrate, and a plurality of lower electrodes formed on one side of the lower surface of the substrate to correspond to the driving circuit unit, the display panel comprising:
a plurality of metal connection patterns connecting the upper electrodes and the lower electrodes via a side surface of the substrate,
wherein each metal connection pattern includes first ends corresponding to the upper electrodes and second ends corresponding to the lower electrodes, respectively, wherein the first end covers an upper surface of the upper electrode and the second end covers a lower surface of the lower electrode.

13. The display panel of claim 12, wherein adhesive layers are not present between the first end of the metal connection pattern and the upper electrode and between the second end and the lower electrode.

14. The display panel of claim 12, wherein the metal thin film is formed by sputtering, chemical vapor deposition, pulsed laser deposition (PLD), E-beam evaporation, thermal evaporation, or metal-organic molecular beam epitaxy (MOMBE).

15. The display panel of claim 12, wherein at least one of the upper electrodes or the lower electrodes is formed using silver paste, molybdenum disulfide (MoS₂), metal meshes or silver nanowires.

16. The display panel of claim 12, wherein the substrate is a TFT glass substrate.
